# EUROPÄISCHE PATENTANMELDUNG

(11) **EP 3 095 714 A1**
(43) Veröffentlichungstag der Anmeldung: **23.11.2016**
(21) Anmeldenummer: 15001501.4
(22) Anmeldetag: 19.05.2015
(51) Int. Cl.: B64G 1/50, B64G 1/10, H05K 7/20

(54) **MODULARER SATELLIT**

(71) Anmelder: Airbus DS GmbH, 82024 Taufkirchen (DE)
(72) Erfinder: Bose, Guido, D-88090 Immenstaad (DE); Grasl, Andreas, D-83101 Rohrdorf/Thansau (DE)
(74) Vertreter: Schicker, Silvia

(57) **Zusammenfassung**

Ein modularer Satellit mit einer Mehrzahl von elektrische und/oder elektronische Baugruppen aufnehmenden Elektronikkästen (3; 122, 123, 124, 125, 126, 127, 128, 129 130, 131), wobei die Elektronikkästen untereinander elektrisch verbunden oder verbindbar sind, ist versehen mit einer Basis-Strukturtafel (108; 208), einer auf der Basis-Strukturtafel (108; 208) angeordneten Dockingstruktur (2; 220), einer Mehrzahl von mit der Dockingstruktur (2; 220) verbundenen oder verbindbaren Geräteträgertafeln (111, 112, 113, 114, 115, 116, 117, 118), wobei die Dockingstruktur (2; 220) erste elektrische Verbindungsmittel (5) zur elektrischen Verbindung mit den Elektronikkästen (3; 122, 123, 124, 125, 126, 127, 128, 129 130, 131) aufweist, wobei die Geräteträgertafeln (111, 112, 113, 114, 115, 116, 117, 118) mechanische Verbindungsmittel (4) zur Halterung der Elektronikkästen (3; 122, 123, 124, 125, 126, 127, 128, 129 130, 131) aufweisen und wobei die jeweilige Geräteträgertafel (111, 112, 113, 114, 115, 116, 117, 118) zumindest bereichsweise mittels integrierter Wärmequellen und/oder Wärmesenken temperierbar ausgebildet ist.

## Beschreibung

### TECHNISCHES GEBIET

Die vorliegende Erfindung betrifft einen modularen Satelliten mit einer Mehrzahl von elektrische und/oder elektronische Baugruppen aufnehmenden Elektronikkästen.

### HINTERGRUND DER ERFINDUNG

Satelliten sind im Allgemeinen Einzelanfertigungen die allenfalls in Stückzahlen von wenigen Exemplaren individuell im Manufakturbetrieb hergestellt und getestet werden. Neben der mechanischen Satellitenstruktur und den für die Lageregelung erforderlichen Antriebs- und Steuerungskomponenten sowie den Stromversorgungskomponenten besteht ein Satellit hauptsächlich aus Nutzlast, die in der Regel von elektrischen und/oder elektronischen Baugruppen gebildet ist. Diese Nutzlast ist üblicherweise in Gehäusen, so genannten Elektronik-Boxen oder Elektronikkästen, untergebracht. In der Raumfahrt müssen daher bei der Integration einer jeden Elektronik-Box mit dem Satelliten individuelle elektrische Verbindungen, mechanische Verbindungen und häufig auch Wärmeübertragungsverbindungen manuell hergestellt und stets getestet werden, was zu einem hohen Fertigungsaufwand am Integrationsarbeitsplatz führt. Dieser Integrationsarbeitsplatz ist daher für diesen langen Zeitraum, den die Integrationstätigkeit einnimmt, belegt.

### STAND DER TECHNIK

Aus der DE 10 2005 044 712 A1 ist ein Avionik-Geräteträgersystem mit einem Schnelleinbaugehäuse für Luftfahrzeuge bekannt. Dieses System weist ein Gehäuse mit Einschubrahmen zur Aufnahme von Einschubmodulen auf. Es ist zum Einbau in einen im Cockpit vorgesehenen Avionik-Baugruppenrahmen ausgestaltet und bildet dort ein Schnelleinbaugehäuse.

### DARSTELLUNG DER ERFINDUNG

Aufgabe der vorliegenden Erfindung ist es, einen modularen Satelliten anzugeben, der in der Phase der Endfertigung schnell integrierbar ist.

Diese Aufgabe wird gelöst durch den modularen Satelliten mit den Merkmalen des Patentanspruchs 1.

Dieser modularer Satellit weist eine Mehrzahl von elektrische und/oder elektronische Baugruppen aufnehmende Elektronikkästen auf, die untereinander elektrisch verbunden oder verbindbar sind, und umfasst eine Basis-Strukturtafel, eine auf der Basis-Strukturtafel angeordnete Dockingstruktur, eine Mehrzahl von mit der Dockingstruktur verbundenen oder verbindbaren Geräteträgertafeln. Die Dockingstruktur weist ihrerseits erste elektrische Verbindungsmittel zur elektrischen Verbindung mit den Elektronikkästen auf und die Geräteträgertafeln weisen mechanische Verbindungsmittel zur Halterung der Elektronikkästen auf. Die jeweilige Geräteträgertafel ist zumindest bereichsweise mittels integrierter Wärmequellen und/oder Wärmesenken temperierbar ausgebildet.

### VORTEILE

Die erfindungsgemäße modulare Bauweise des Satelliten gestattet es, einzelne Komponenten, wie beispielsweise die Elektronikkästen, andernorts vorzufertigen und zu testen, so dass sie am Integrationsplatz des Satelliten nur noch mit der Geräteträgertafel und der Dockingstruktur auf Inter-Funktionsfähigkeit getestet und verbunden werden müssen, da sie bereits als, zum Beispiel mittels einer eingebauten Testeinrichtung, auch hinsichtlich der Schnittstellen getestete Komponenten angeliefert werden können. Auch die einzelnen Geräteträgertafeln können vorproduziert werden, so dass sie bei der Integration des Satelliten als vorgefertigte und auf Funktionsfähigkeit getestete Komponenten integriert werden können. Dadurch wird nicht nur die Integrationszeit des Satelliten deutlich reduziert, sondern auch die Kapazität vorhandener Integrationsarbeitsplätze wesentlich erhöht. Es werden so die Voraussetzungen für die wirtschaftliche Fertigung einer größeren Satelliten-Stückzahl geschaffen.

Weitere bevorzugte und vorteilhafte Ausgestaltungsmerkmale des modularen Satelliten nach der Erfindung sind Gegenstand der Unteransprüche 2 bis 15.

In einer vorteilhaften Weiterbildung der Erfindung bilden die mechanischen Verbindungsmittel der Geräteträgertafeln und die diesen zugeordneten elektrischen Verbindungsmittel der Dockingstruktur Dockingstationen für die Elektronikkästen, wobei zumindest ein Teil der Dockingstationen gleichartig ausgebildet und in einem Raster angeordnet ist, um Aufnahmenischen für die Elektronikkästen zu bestimmen. Eine solche Dockingstruktur mit gleichartig ausgestalteten Dockingstationen ermöglicht es, ebenso "standardisiert" ausgebildete Elektronikkästen in eine beliebige, eine Dockingstation der Dockingstruktur bildende Aufnahmenische einzusetzen. Es wird auf diese Weise ein kompakter, nach Art eines Racks gebildeter Satellit geschaffen.

Vorzugsweise ist die Dockingstruktur als gitterartiges Kastenprofil ausgebildet, in dessen Innerem elektrische Versorgungs- und Verbindungsleitungen verlaufen, die mit den elektrischen Verbindungsmitteln elektrisch leitend verbunden sind. Auch eine Thermo-Infrastruktur zur Versorgung der in den Geräteträgertafeln vorgesehenen Wärmequellen beziehungsweise Wärmesenken kann innerhalb des kastenartigen Profils der Dockingstruktur untergebracht sein.

Es ist von Vorteil, wenn die in die Geräteträgertafel integrierten Wärmequellen und/oder Wärmesenken in einer Grundplatte der Geräteträgertafel vorgesehen sind. So steht der Raum auf der Grundplatte vollständig für die Aufnahme und Abstützung eines zugeordneten Elektronikkastens zur Verfügung und die für die Wärmeübertragung erforderliche Kontaktfläche zwischen dem Elektronikkasten und der Grundplatte ist maximiert.

Vorteilhaft ist dabei, wenn die Grundplatte im Bereich der ersten mechanischen Verbindungsmittel mit zumindest einer Wärmekontaktfläche versehen ist, auf der ein mit den mechanischen Verbindungsmitteln in Eingriff stehender Elektronikkasten mit einer Gehäusefläche in wärmeleitendem Kontakt aufliegt, und wenn dadurch die zumindest eine Wärmekontaktfläche mit der in die Grundplatte integrierten Wärmequelle und/oder Wärmesenke in wärmeleitendem Kontakt steht.

In einer Ausführungsform ist die Grundplatte zumindest bereichsweise mit Wärmeleiteinrichtungen ausgestattet ist, die ausgestaltet sind, um auf die Grundplatte oder auf einen Bereich der Grundplatte einwirkende Wärme oder Kälte durch Wärmeleitung abzutransportieren.

Vorzugsweise weisen die Wärmeleiteinrichtungen Heatpipes auf, die an oder in der Grundplatte vorgesehen sind. Dabei sind die Heatpipes bevorzugt von im Inneren der Grundplatte verlaufenden Bahnen aus einem wärmeleitenden Material, vorzugsweise aus einem Metall, gebildet.

Alternativ können die Heatpipes von im Inneren der Grundplatte verlaufenden Kanälen aus einem wärmeleitenden Material, vorzugsweise aus einem Metall, gebildet sein, die von einem Wärmetransportmedium durchströmt oder durchströmbar sind.

Besonders vorteilhaft ist es, wenn die Grundplatte mit Wärmeleit-Kupplungseinrichtungen versehen ist, die mit den Wärmeleiteinrichtungen in wärmeleitender Verbindung stehen und die mit anderen Wärmeleiteinrichtungen außerhalb der Grundplatte wärmeleitend kuppelbar sind. Dies ermöglicht eine schnelle Integration einer Geräteträgertafel, die eine solche Thermo-Grundplatte aufweist, mit der in der Dockingstruktur vorgesehenen Thermo-Infrastruktur.

Zusätzlich oder alternativ zu den Wärmeleiteinrichtungen ist die Grundplatte zumindest bereichsweise mit elektrischen Kühl- und/oder Heizeinrichtungen ausgestattet, die ausgebildet sind, um die Grundplatte oder einen Bereich der Grundplatte unmittelbar zu kühlen oder zu erwärmen.

Es ist besonders vorteilhaft, wenn eine Mehrzahl von individuell ansteuerbaren Wärmeleiteinrichtungen und/oder Kühl- und/oder Heizeinrichtungen über die Fläche der Grundplatte verteilt vorgesehen ist. Diese Ausgestaltung ermöglicht es, eine lokal bedarfsgerechte Kühlung und/oder Heizung der Grundplatte und damit des auf der Grundplatte aufliegenden Elektronikkastens zu erzielen.

Dabei ist vorteilhaferweise jeder der individuell ansteuerbaren Wärmeleiteinrichtungen und/oder Kühl- und/oder Heizeinrichtungen zumindest ein Temperatursensor in oder auf der Grundplatte zugeordnet, wodurch eine genaue lokale Temperatursteuerung oder Temperaturregelung ermöglicht wird.

In einer vorteilhaften Weiterbildung der Erfindung ist eine Temperatursteuerungseinrichtung vorgesehen, die mit den Temperatursensoren über Signalleitungen verbunden ist und die über Steuerleitungen mit den individuell ansteuerbaren Wärmeleiteinrichtungen und/oder Kühl- und/oder Heizeinrichtungen verbunden ist.

Dabei ist es von besonderem Vorteil, wenn die Temperatursteuerungseinrichtung auf der Grundplatte oder in die Grundplatte integriert vorgesehen ist.

Die Abmessung sowie geometrische Form der Elektronikboxen können sowohl hinsichtlich der Größe als auch hinsichtlich ihrer Form grundsätzlich beliebig ausgestaltet sein. Die Abmessungen sollten lediglich innerhalb einmal vorgegebener Maximalabmessungen entsprechen, so dass der Einbauraum, die Grundrissmaße (Länge und Breite) sowie die Gestalt und Anordnung der elektrischen und mechanischen Verbindungselemente definiert sind. Dadurch wird die Kompatibilität zwischen den mechanischen und den elektrischen Verbindungselementen sichergestellt.

Bevorzugte Ausführungsbeispiele der Erfindung mit zusätzlichen Ausgestaltungsdetails und weiteren Vorteilen sind nachfolgend unter Bezugnahme auf die beigefügten Zeichnungen näher beschrieben und erläutert.

### KURZE BESCHREIBUNG DER ZEICHNUNGEN

Es zeigt:
- Fig. 1: eine schematische perspektivische Darstellung eines erfindungsgemäßen modularen Satelliten;
- Fig. 2: eine perspektivische Explosionsansicht des Satelliten aus Fig. 1;
- Fig. 3: eine perspektivische Ansicht eines Ausschnitts einer Geräteträgertafel mit Dockingstruktur und einem Elektronikkasten;
- Fig. 4: eine perspektivische Ansicht einer Grundplatte einer erfindungsgemäßen Geräteträgertafel mit Wärmeleiteinrichtungen;
- Fig. 5: eine perspektivische Ansicht einer Grundplatte einer erfindungsgemäßen Geräteträgertafel mit elektrischen Heizeinrichtungen;
- Fig. 6: eine Abwandlung des Satelliten aus Fig. 2 mit erweiterter Basis;
- Fig. 7: eine Rückansicht des Satelliten aus Fig. 6 und
- Fig. 8: eine Abwandlung des Satelliten aus Fig. 7.

### DARSTELLUNG VON BEVORZUGTEN AUSFÜHRUNGSBEISPIELEN

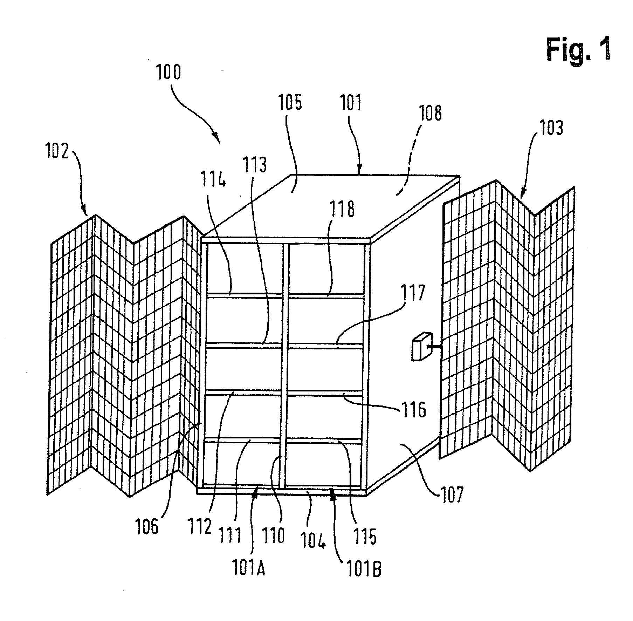

In Fig. 1 ist ein modularer Satellit 100 gemäß einem ersten Ausführungsbeispiel der Erfindung schematisch dargestellt. Der Satellit 100 besteht aus einem Korpus 101, an dem an zwei voneinander abgewandten Seiten jeweils ein entfaltbares Solarpanel 102, 103 angebracht ist.

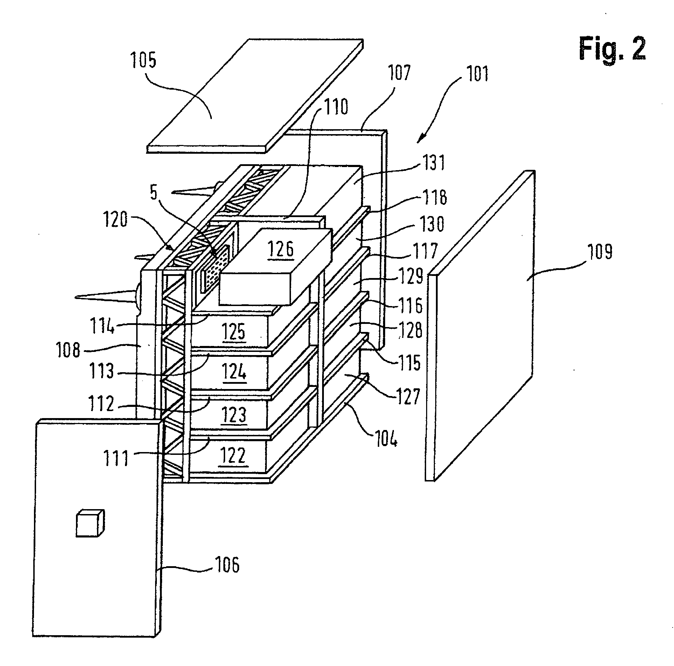

Der Korpus 101 besitzt eine quaderförmige Gestalt mit einer unteren Bodenwandtafel 104, einer oberen Deckenwandtafel 105, einer ersten Seitenwandtafel 106 und einer zweiten Seitenwandtafel 107. Die in Fig. 1 nicht sichtbaren, aber in Fig. 2 gezeigte Rückwand des quaderförmigen Korpus 101 ist von einer Basisstrukturtafel 108 gebildet. Eine vordere Wandtafel 109 (Fig. 2) ist in Fig. 1 nicht dargestellt.

Durch das Weglassen der vorderen Wandtafel 109 in Fig. 1 erkennt man den registerartigen inneren Aufbau des Korpus 101. Eine mittlere vertikale Trennwandtafel 110, die parallel zu den Seitenwandtafeln 106, 107 verläuft, teilt das Innere des Korpus in zwei gleich breite Innenraumbereiche 101A, 101B. Jeder dieser beiden Innenraumbereiche ist durch vier Geräteträgertafeln 111, 112, 113, 114 beziehungsweise 115, 116, 117, 118, die rechtwinklig zur vertikalen Trennwandtafel 110 und parallel zur Bodentafel 104 und zur Deckentafel 105 verlaufen, in fünf gleich hohe Aufnahmeräume für jeweils einen Elektronikkasten unterteilt.

In Fig. 2 ist zu erkennen, dass die Basis-Strukturtafel 108 auf ihrer zur Innenseite des Korpus 101 weisenden Oberfläche mit einer als gitterartiges Kastenprofil ausgebildeten Dockingstruktur 2 versehen ist, die weiter unten noch erläutert werden wird. Die Dockingstruktur 2 ist auf ihrer von der Basis-Strukturtafel 108 abgewandten Seite mit elektrischen Verbindungsmitteln 5 versehen.

In jedem der Aufnahmefächer ist im Beispiel der Fig. 2 ein Elektronikkasten 122, 123, 124, 125, 126 beziehungsweise 127, 128, 129, 130, 131 eingesetzt. Im Beispiel der Fig. 2 ist zu erkennen, dass der oberste linke Elektronikkasten 126 nicht vollständig eingesetzt ist, so dass die diesem Aufnahmefach zugeordneten elektrischen Verbindungsmittel 5 der Dockingstruktur 2 sichtbar sind.

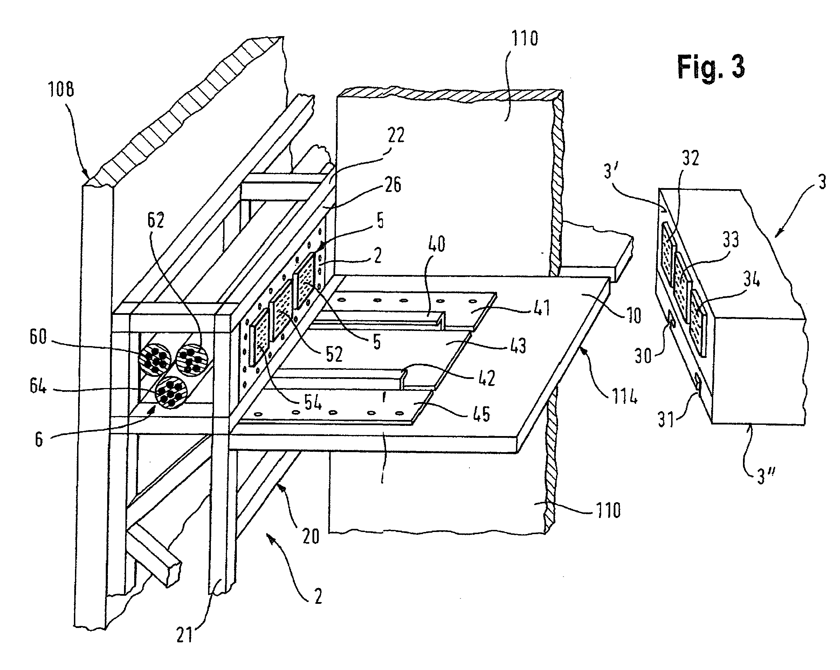

Fig. 3 zeigt in vergrößerter Darstellung ein Aufnahmefach mit der Geräteträgertafel 114. Die Geräteträgertafel 114 ist mit der Dockingstruktur 2 fest verbunden. Die weiteren Aufnahmefächer des Korpus 101 sind in derselben Weise aufgebaut, so dass auf deren Beschreibung zur Vermeidung von Wiederholungen verzichtet wird. Für die beiden untersten Aufnahmefächer des Korpus 101 ist die Bodenplatte 104 ebenfalls als Geräteträgerplatte ausgestaltet, wie sie nachstehend beschrieben wird.

Die Dockingstruktur 2 besteht aus einem kastenartigen Gittergerüst 20, welches aus einem Leichtmaterial, wie beispielsweise einem Kohlefaser-Verbundwerkstoff (CFK) oder einem Leichtmetall (z. B. Aluminium) gebildet ist. Die Dockingstruktur 2 weist vier äußere Seiten auf, die im Wesentlichen rechtwinklig zur Ausdehnungsfläche der Basis-Strukturtafel 108 ausgerichtet sind und von denen in Fig. 3 nur die linke Seite 21 und die obere Seite 22 gezeigt ist. Die von der Basis-Strukturtafel 108 abgewandte vordere Seite 26 der Dockingstruktur 2 verläuft im Wesentlichen parallel zur Fläche der Basis-Strukturtafel 108.

Im Inneren der Dockingstruktur 2 verlaufen elektrische Versorgungs- und Verbindungsleitungen 6, die im gezeigten Beispiel drei Kabelbäume 60, 62, 64 umfassen.

Das Gittergerüst 20 kann mit Abdeckplatten 28 versehen sein, die Bereiche des Gittergerüstes 20 verschließen oder verkleiden. Im gezeigten Beispiel ist lediglich eine Abdeckplatte 28 an der oberen Seite 26 des gezeigten Aufnahmefachs dargestellt; auch die anderen Aufnahmefächer sind durch eine solche Abdeckplatte zur Dockingstruktur 2 abgeschlossen. Derartige Abdeckplatten können auch an den äußeren Seiten des Gittergerüsts 20 angebracht sein.

Die Abdeckplatte 28 ist mit drei elektrischen Steckverbindern 50, 52, 54 versehen, die zusammen erste elektrische Verbindungsmittel 5 der Dockingstruktur 2 bilden. Diese Steckverbinder 50, 52, 54 sind mit dem im Inneren der Dockingstruktur 2 verlaufenden elektrischen Versorgungs- und Verbindungsleitungen elektrisch verbunden.

Unterhalb der Abdeckplatte 28 ist die Geräteträgertafel 114 mechanisch fest mit der Basis-Strukturtafel 108 und/oder mit dem Gittergerüst 20 der Dockingstruktur 2 verbunden. Die Geräteträgertafel 114 weist eine Grundplatte 10 auf. Vor dem mit der Abdeckplatte 28 versehenen Abschnitt der Dockingstruktur 2 sind auf der Grundplatte 10 der Geräteträgertafel 114 rechtwinklig zur Erstreckung der Abdeckplatte 28 zwei seitlich voneinander beabstandete Schienen 40, 42 angebracht, die mechanische Verbindungsmittel 4 bestimmen. Zwischen den beiden Schienen 40, 42 und jeweils seitlich neben diesen Schienen sind plattenartige Wärmekontaktflächen 41, 43, 45 auf der Grundplatte 10 angebracht, die in engem wärmeleitenden Kontakt mit der Grundplatte 10 stehen wie weiter unten noch beschrieben wird.

In Fig. 3 ist weiterhin ein Elektronikkasten 3 gezeigt, der dem Elektronikkasten 126 in Fig. 2 entspricht und der elektronische Baugruppen (zum Beispiel Geräte und/oder elektronische Schaltungsanordnungen) aufnimmt. Auf der in der perspektivischen Ansicht der Fig. 3 sichtbaren und der Abdeckplatte 28 der Dockingstruktur 2 zugewandten Stirnseite 3' des Elektronikkastens 3 sind drei elektrische Steckverbinder 32, 33, 34 vorgesehen, die jeweils ein elektrisches Gegenverbindungsmittel zum entsprechend gegenüber gelegenen Steckverbinder 50, 52, 54 der Abdeckplatte 28 bilden. Im unteren Bereich der Stirnseite 3' des Elektronikkastens 3 sind mechanische Gegenverbindungsmittel 30, 31 vorgesehen, die als Nuten ausgebildet sind, welche im Querschnitt dem Querschnitt der Schienen 40, 42 entsprechen und sich an der Unterseite des Elektronikkastens 3 entlang erstrecken.

Der Elektronikkasten 3 kann auf diese Weise auf die Schienen 40, 42 aufgeschoben werden, indem diese Schienen 40, 42 in eine jeweils zugeordnete Nut (mechanische Gegenverbindungsmittel 30, 31) eingeführt werden. Der Elektronikkasten 3 kann dann schubladenartig entlang der Schienen 40, 42 in Richtung auf die Abdeckplatte 28 der Dockingstruktur 2 geschoben werden, bis die elektrischen Steckverbinder 50, 52, 54 der ersten elektrischen Verbindungsmittel 5 mit den entsprechenden elektrischen Gegenverbindungsmitteln 32, 33, 34 an der Stirnseite 3' des Elektronikkastens 3 in Eingriff geraten und elektrische Verbindungen zwischen dem Elektronikkasten 3 und der Dockingstruktur 2 herstellen. In dieser elektrisch kontaktierenden Position wird der Elektronikkasten 3 über (nicht gezeigte) Arretiermittel an der Dockingstruktur 2 und/oder an der Grundplatte 10 fixiert. Der Elektronikkasten 3 liegt dabei mit seiner Unterseite 3" auf den thermischen Kontaktplatten 41, 43, 45 auf und stellt dort eine flächige thermisch leitende Verbindung her.

Die Geräteträgertafel 114 ist (wie auch die anderen Geräteträgertafeln) als temperierbare Thermotransfertafel ausgebildet und dazu zumindest bereichsweise mit integrierten Wärmequellen und/oder Wärmesenken versehen.

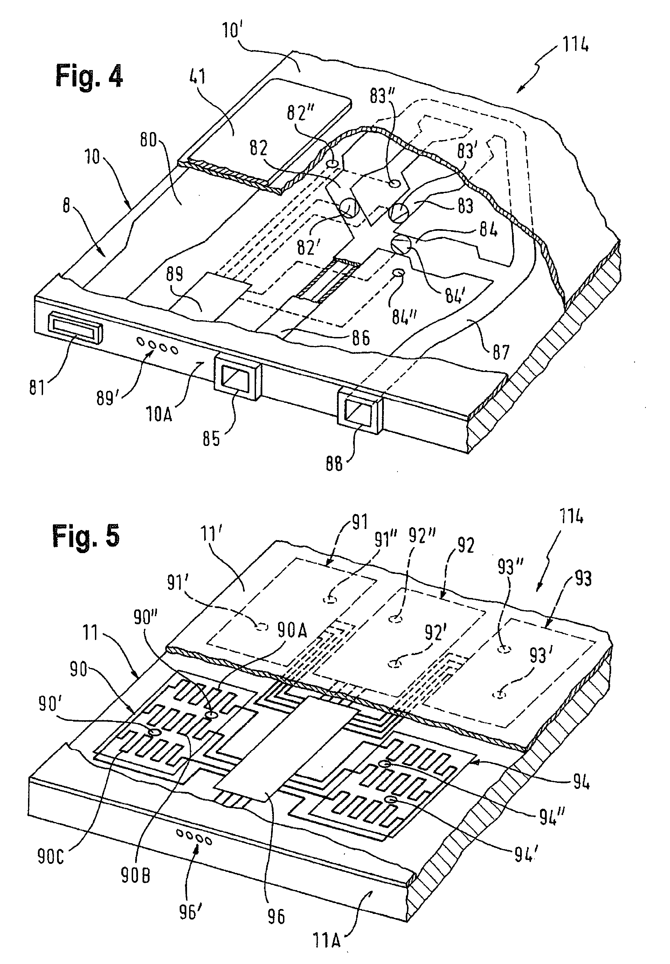

Fig. 4 zeigt in perspektivischer Ansicht die teilweise aufgeschnittene Geräteträgertafel 114 in einer ersten Ausführungsform. In die Grundplatte 10 der Geräteträgertafel 114 sind Wärmeleiteinrichtungen 8 integriert. Die Wärmeleiteinrichtungen 8 sind im gezeigten Beispiel der Fig. 4 in zwei unterschiedlichen Varianten dargestellt.

Eine erste Variante der Wärmeleiteinrichtungen weist eine im Inneren der Grundplatte 10 vorgesehene Wärmeleitschicht 80 aus einem gut wärmeleitenden Material, zum Beispiel einem Metall wie Kupfer oder Aluminium, auf und bildet eine passive Wärmeleiteinrichtung. Auf ihrer Oberseite ist die Grundplatte 10 mit einer gut wärmeleitenden Deckschicht 10' versehen, die in direkter, wärmeübertragender Verbindung mit der Wärmeleitschicht 80 steht. Zusätzlich ist lokal oberhalb der Wärmeleitschicht 80 eine thermische Kontaktplatte 41 angeordnet, die mit der Wärmeleitschicht 80 entweder unmittelbar oder mittelbar über die Deckschicht 10' in wärmeleitender Verbindung steht. Auf der thermischen Kontaktplatte 41 ist der zugeordnete Elektronikkasten platziert, so dass die in ihm erzeugte Wärme durch die thermische Kontaktplatte 41 in die Wärmeleitschicht 80 abgeführt wird.

Die Wärmeleitschicht 80 mündet in einer Stirnseite 10A der Grundplatte 10 in eine erste Wärmeleit-Kupplungseinrichtung 81, über die beim Einbau der Geräteträgertafel 1 in die Satelliten-Infrastruktur eine Wärmeleitverbindung zur Basis-Strukturtafel 108 oder zu einem nicht näher gezeigten Wärmeleitkanal der Satelliten-Infrastruktur herstellbar ist. Auf diese Weise kann die von dem auf der Geräteträgerplatte 114 angeordneten Elektronikkasten 126 in die Grundplatte 10 eingeleitete Wärme zu an den Wärmeleitkanal angeschlossenen Wärmesenken abgeleitet werden. Eine derartige Wärmesenke kann beispielsweise die Basis-Strukturtafel 108 sein, die sich auf der Schattenseite des Satelliten befindet.

In Fig. 4 ist noch eine zweite Variante der Wärmeleiteinrichtungen 8 dargestellt, die aktiv arbeitet. Dazu ist im Inneren der Grundplatte ein System von Kanälen 82, 83, 84 aus einem gut wärmeleitenden Material, zum Beispiel einem Metall, wie beispielsweise Kupfer oder Aluminium, vorgesehen. Die Kanäle 82, 83, 84, die in ihrer Breitenabmessung variieren können, wie in Fig. 4 zu erkennen ist, sind hohl und werden von einem Wärmetransportfluid durchströmt. Eine zweite Wärmeleit-Kupplungseinrichtung 85 ist in der Stirnseite 10A der Grundplatte 10 vorgesehen und ein Zulaufkanal 86 verläuft von dort im Inneren der Grundplatte 10 zu den Kanälen 82, 83, 84. Steuerbare Ventile 82', 83', 84' sind jeweils im zugeordneten Kanal 82, 83, 84 angeordnet, um den Durchfluss des Wärmetransportfluids zu steuern. Die Kanäle 82, 83, 84 münden hinter den Ventilen 82', 83', 84' in einen gemeinsamen Rücklaufkanal 87, der zu einer dritten, in der Stirnseite 10A der Grundplatte 10 vorgesehenen Wärmeleit-Kupplungseinrichtung 88 verläuft. Auch wenn das in Fig. 4 nicht explizit dargestellt ist, kann auch bei dieser Variante zumindest eine thermische Kontaktplatte 41 in derselben Weise wie die in Verbindung mit der ersten Variante beschrieben worden ist, vorgesehen sein.

Dem jeweiligen Kanal 82, 83, 84 ist jeweils zumindest ein Temperatursensor 82", 83", 84" zugeordnet. Die Temperatursensoren 82", 83", 84" und auch die steuerbaren Ventile 82', 83', 84' stehen über gestrichelt gezeichnete Signalleitungen mit einer Temperatursteuerungseinrichtung 89 in elektrisch leitender Verbindung. Die Temperatursteuerungseinrichtung 89 ist im gezeigten Beispiel als in das Innere der Grundplatte 10 integrierte Komponente dargestellt, sie kann aber auch anderweitig an oder auf der Grundplatte 10 vorgesehen sein und ist auf jeden Fall Bestandteil der die Grundplatte 10 aufweisenden Geräteträgertafel 114. Elektrische Kontakteinrichtungen 89' sind in der Stirnseite 10A der Grundplatte 10 vorgesehen und dienen dazu, elektrische Verbindungen zu einer Stromversorgungseinheit und zu einer zentralen Kontrolleinrichtung des Satelliten herzustellen.

Obwohl in Fig. 4 zwei unterschiedliche Varianten der Wärmeleiteinrichtungen 8 dargestellt sind, ist es für den Fachmann klar, dass er in einer Grundplatte 10 auch ausschließlich die erste, passive Variante oder ausschließlich die zweite, aktive Variante vorsehen kann. Selbstverständlich ist es aber auch möglich, die beiden Varianten in beliebiger Weise unabhängig nebeneinander (wie in Fig. 4 gezeigt) oder miteinander kombiniert in einer Grundplatte vorzusehen.

Fig. 5 zeigt eine zweite, alternative Ausführungsform einer Grundplatte 11 der Geräteträgertafel 114, wobei die Grundplatte 11 mit einer Mehrzahl von elektrischen Heizeinrichtungen 90, 91, 92, 93, 94 versehen ist. Die elektrischen Heizeinrichtungen 90, 91, 92, 93, 94 können, wie in Fig. 5 dargestellt ist, im Inneren der Grundplatte 11 vorgesehen und von einer gut wärmeleitenden Deckschicht 11' abgedeckt sein, die in direkter, wärmeübertragender Verbindung mit den elektrischen Heizeinrichtungen 90, 91, 92, 93, 94 steht. Die elektrischen Heizeinrichtungen 90, 91, 92, 93, 94 können von Folienheizelemente gebildet sein und jeweils zumindest einen Temperatursensor 90', 90", 91', 91 ", 92', 92", 93', 93", 94', 94" aufweisen.

Wie in Fig. 5 gezeigt ist, kann jede der elektrischen Heizeinrichtungen 90, 91, 92, 93, 94 getrennt voneinander ansteuerbare Heizbereiche (zum Beispiel 90A, 90B, 90C) aufweisen. Jeder Heizbereich einer jeden Heizeinrichtung 90, 91, 92, 93, 94 steht über eine eigene Stromversorgungsleitung (in Fig. 5 gestrichelt gezeichnet) mit einer in, an oder auf der Grundplatte 11 vorgesehenen Temperatursteuerungseinrichtung 96 in elektrisch leitender Verbindung. Auch die jeweiligen in oder auf der Grundplatte 11 vorgesehenen Temperatursensoren 90', 90", 91', 91 ", 92', 92", 93', 93", 94', 94" sind über eine jeweilige Signalleitung (in Fig. 5 gestrichelt gezeichnet) mit der Temperatursteuerungseinrichtung 96 zur Signalübertragung elektrisch leitend verbunden. Die Temperatursteuerungseinrichtung 96 ist so in der Lage, die elektrische Energie, die jedem Heizbereich einer jeden Heizeinrichtung 90, 91, 92, 93, 94 zugeführt wird, unter Berücksichtigung der Signale der Temperatursensoren 90', 90", 91', 91", 92', 92", 93', 93", 94', 94" zu regeln. Über in der Stirnseite 11 A der Grundplatte 11 vorgesehene elektrische Kontakte 96' wird die Temperatursteuerungseinrichtung 96 im in den Satelliten eingebauten Zustand der die Grundplatte 11 aufweisenden Geräteträgertafel 114 mit elektrischer Energie versorgt und steht außerdem im Datenaustausch mit einer übergeordneten Thermomanagement-Steuerungseinrichtung des Satelliten.

Die elektrischen Heizeinrichtungen 90, 91, 92, 93, 94 sind, vorzugsweise in einem gleichmäßigen Raster, über die Fläche der Grundplatte 11 oder zumindest über einen Bereich der Fläche der Grundplatte 11 verteilt angeordnet. Dadurch ist es möglich, die Grundplatte lokal unterschiedlich intensiv und lokal temperaturgeregelt zu heizen.

Auch wenn die beschriebenen Ausführungsformen der Fig. 4 und 5 in den Figuren separat dargestellt ist, können die Ausführungsformen der Fig. 4 und 5 beliebig miteinander kombiniert werden. Ebenso kann auch bei dieser Ausführungsform mit elektrischen Heiz-/Kühleinrichtungen zumindest eine thermische Kontaktplatte 41 in derselben Weise wie die in Verbindung mit der ersten Ausführungsform beschrieben worden ist, vorgesehen sein.

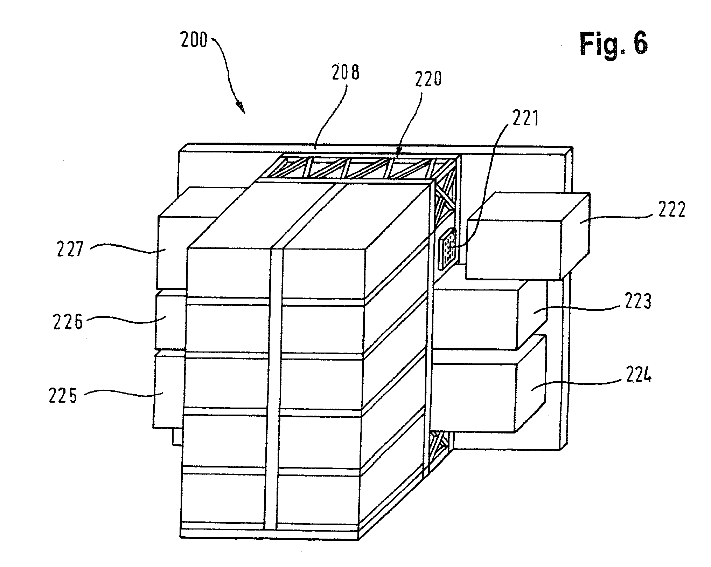

Fig. 6 zeigt eine abgewandelte Ausführungsform des erfindungsgemäßen Satelliten 200, bei welchem die Basis-Strukturtafel 208 seitlich über die Dockingstruktur 220 hinausragt und bei welcher an diesen Seiten der Dockingstruktur 220, an denen die Basis-Strukturplatte 208 über die Dockingstruktur 220 hinaussteht, ebenfalls elektrische Verbindungseinrichtungen 221 für den Anschluss von zusätzlichen Elektronikkästen 222, 223, 224, 225, 226, 227 vorgesehen sind. Entsprechende (nicht gezeigte) mechanische Verbindungsmittel sind auf der Basis-Strukturtafel 208 in derselben Weise angebracht, wie dies in Verbindung mit Fig. 3 in Bezug auf die Grundplatte 10 beschrieben worden ist. Die Basis-Strukturtafel 208, die im Betrieb des Satelliten 200 der Erde zugewandt ist, also auf der von der Sonne abgewandten kälteren Schattenseite des Satelliten liegt, ist hochwärmeleitend ausgebildet und gibt die von den Elektronikkästen aufgenommene Wärme großflächig an den Weltraum ab.

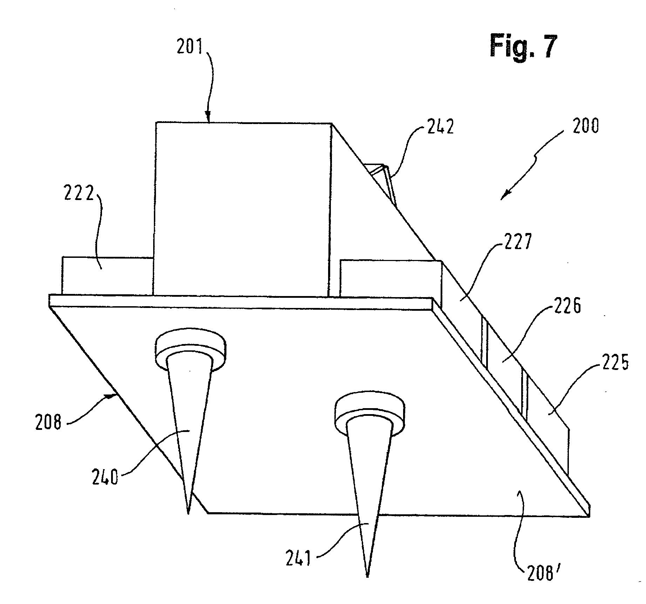

Fig. 7 zeigt die Variante der Fig. 6 von der der Erde zugewandten Seite der Basis-Strukturtafel 208 mit verkleidetem Korpus 201, der im Aufbau dem in Verbindung mit den Fig. 1 und 2 beschriebenen Korpus 101 entspricht. Die Seitenwandtafeln 106, 107 des Korpus 101 können auf ihrer Innenseite mit einer elastischen, wärmeleitenden Folie, wie sie beispielsweise unter dem Handelsnamen Sikaflex^{®} bekannt ist, versehen sein, die im montierten Zustand des Korpus 101 gegen die Elektronikkästen anliegt und Wärme von den Elektronikkästen zur betreffenden Seitenwand ableitet.

Auf der der Erde zugewandten Rückseite 208' der Basis-Strukturtafel 208 sind zwei kegelförmige Antennen 240, 241 schematisch dargestellt, über die Funkverbindungen mit einer Bodenstation unterhalten werden können. Zusätzlich ist auf dem Korpus 201 eine Laserkommunikationseinrichtung 242 dargestellt.

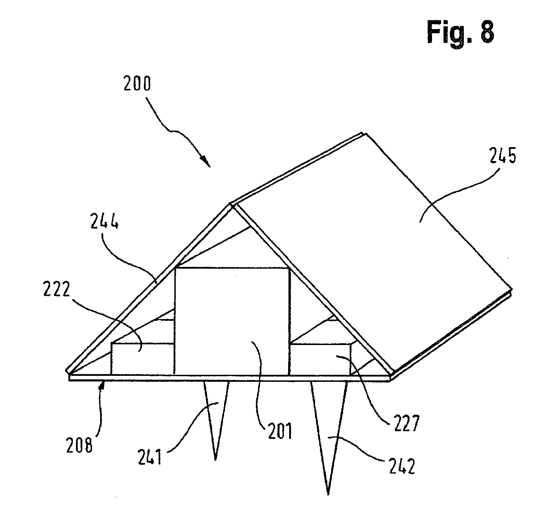

Fig. 8 zeigt den Satelliten aus Fig. 7, wobei auf der Basis-Strukturtafel 208 zwei die äußeren Elektronikkästen 222, 223, 224, 225, 226, 227 und den Korpus 201 dachartig überdeckende Platten 244, 245 vorgesehen sind. Diese dachartigen Platten 244, 245 können mit Solarpanelen bedeckt sein und den Satelliten 200 mit elektrischer Energie versorgen.

Bezugszeichen in den Ansprüchen, der Beschreibung und den Zeichnungen dienen lediglich dem besseren Verständnis der Erfindung und sollen den Schutzumfang nicht einschränken.

## Patentansprüche

1. Modularer Satellit mit einer Mehrzahl von elektrische und/oder elektronische Baugruppen aufnehmenden Elektronikkästen (3; 122, 123, 124, 125, 126, 127, 128, 129 130, 131), wobei die Elektronikkästen untereinander elektrisch verbunden oder verbindbar sind, mit
- einer Basis-Strukturtafel (108; 208),
- einer auf der Basis-Strukturtafel (108; 208) angeordneten Dockingstruktur (2; 220),
- einer Mehrzahl von mit der Dockingstruktur (2; 220) verbundenen oder verbindbaren Geräteträgertafeln (111, 112, 113, 114, 115, 116, 117, 118),
- wobei die Dockingstruktur (2; 220) erste elektrische Verbindungsmittel (5) zur elektrischen Verbindung mit den Elektronikkästen (3; 122, 123, 124, 125, 126, 127, 128, 129 130, 131) aufweist,
- wobei die Geräteträgertafeln (111, 112, 113, 114, 115, 116, 117, 118) mechanische Verbindungsmittel (4) zur Halterung der Elektronikkästen (3; 122, 123, 124, 125, 126, 127, 128, 129 130, 131) aufweisen und
- wobei die jeweilige Geräteträgertafel (111, 112, 113, 114, 115, 116, 117, 118) zumindest bereichsweise mittels integrierter Wärmequellen und/oder Wärmesenken temperierbar ausgebildet ist.

2. Modularer Satellit nach einem der vorhergehenden Ansprüche,
**dadurch gekennzeichnet,**
**dass** die mechanischen Verbindungsmittel (4) der Geräteträgertafeln (111, 112, 113, 114, 115, 116, 117, 118) und die diesen zugeordneten elektrischen Verbindungsmittel (5) der Dockingstruktur (2; 220) Dockingstationen für die Elektronikkästen (3; 122, 123, 124, 125, 126, 127, 128, 129 130, 131) bilden und dass zumindest ein Teil der Dockingstationen gleichartig ausgebildet und in einem Raster angeordnet ist, um Aufnahmenischen für die Elektronikkästen (3; 122, 123, 124, 125, 126, 127, 128, 129 130, 131) zu bestimmen.

3. Modularer Satellit nach Anspruch 1 oder 2
**dadurch gekennzeichnet,**
**dass** die Dockingstruktur (2; 220) als gitterartiges Kastenprofil ausgebildet ist, in dessen Innerem elektrische Versorgungs- und Verbindungsleitungen (6) verlaufen, die mit den elektrischen Verbindungsmitteln (5) verbunden sind.

4. Modularer Satellit nach Anspruch 1, 2 oder 3,
**dadurch gekennzeichnet,**
**dass** die in die Geräteträgertafel (111, 112, 113, 114, 115, 116, 117, 118) integrierten Wärmequellen und/oder Wärmesenken in einer Grundplatte (10; 11) der Geräteträgertafel vorgesehen sind.

5. Modularer Satellit nach Anspruch 4,
**dadurch gekennzeichnet,**
- **dass** die Grundplatte (10; 11) im Bereich der ersten mechanischen Verbindungsmittel (4) mit zumindest einer Wärmekontaktfläche (41, 43, 45) versehen ist, auf der ein mit den mechanischen Verbindungsmitteln (4) in Eingriff stehender Elektronikkasten (3) mit einer Gehäusefläche (3") in wärmeleitendem Kontakt aufliegt, und
- **dass** die zumindest eine Wärmekontaktfläche (41, 43, 45) mit einer in die Grundplatte (10; 11) integrierten Wärmequelle und/oder Wärmesenke in wärmeleitendem Kontakt steht.

6. Modularer Satellit nach Anspruch 4 oder 5,
**dadurch gekennzeichnet,**
**dass** die Grundplatte (10) zumindest bereichsweise mit Wärmeleiteinrichtungen (8) ausgestattet ist, die ausgestaltet sind, um auf die Grundplatte (10) oder auf einen Bereich der Grundplatte (10) einwirkende Wärme oder Kälte durch Wärmeleitung abzutransportieren.

7. Modularer Satellit nach Anspruch 6,
**dadurch gekennzeichnet,**
**dass** die Wärmeleiteinrichtungen (8) Heatpipes (80; 82, 83, 84, 86, 87) aufweisen, die an oder in der Grundplatte (10) vorgesehen sind.

8. Modularer Satellit nach Anspruch 7,
**dadurch gekennzeichnet,**
**dass** die Heatpipes (80) gebildet sind von im Inneren der Grundplatte (10) verlaufenden Bahnen aus einem wärmeleitenden Material, vorzugsweise aus einem Metall.

9. Modularer Satellit nach Anspruch 7,
**dadurch gekennzeichnet,**
**dass** die Heatpipes (82, 83, 84, 86, 87) gebildet sind von im Inneren der Grundplatte (10) verlaufenden Kanälen aus einem wärmeleitenden Material, vorzugsweise aus einem Metall, die von einem Wärmetransportmedium durchströmt oder durchströmbar sind.

10. Modularer Satellit nach einem der Ansprüche 6 bis 9,
**dadurch gekennzeichnet,**
**dass** die Grundplatte (10) mit Wärmeleit-Kupplungseinrichtungen (81; 85, 88) versehen ist, die mit den Wärmeleiteinrichtungen (8) in wärmeleitender Verbindung stehen und die mit anderen Wärmeleiteinrichtungen außerhalb der Grundplatte (10) wärmeleitend kuppelbar sind.

11. Modularer Satellit nach einem der Ansprüche 4 bis 10,
**dadurch gekennzeichnet,**
**dass** die Grundplatte (11) zumindest bereichsweise mit elektrischen Kühl-und/oder Heizeinrichtungen (90, 91, 92, 93, 94) ausgestattet ist, die ausgebildet sind, um die Grundplatte (11) oder einen Bereich der Grundplatte (11) unmittelbar zu kühlen oder zu erwärmen.

12. Modularer Satellit nach einem der Ansprüche 6 bis 11,
**dadurch gekennzeichnet,**
**dass** eine Mehrzahl von individuell ansteuerbaren Wärmeleiteinrichtungen (82, 83, 84) und/oder Kühl- und/oder Heizeinrichtungen (90, 91, 92, 93, 94) über die Fläche der Grundplatte (10; 11) verteilt vorgesehen ist.

13. Modularer Satellit nach Anspruch 12,
**dadurch gekennzeichnet,**
**dass** jeder der individuell ansteuerbaren Wärmeleiteinrichtungen (82, 83, 84) und/oder Kühl- und/oder Heizeinrichtungen (90, 91, 92, 93, 94) zumindest ein Temperatursensor (82", 83", 84"; 90', 90", 91', 91", 92', 92", 93', 93", 94', 94") in oder auf der Grundplatte (10; 11) zugeordnet ist.

14. Modularer Satellit nach Anspruch 13,
**dadurch gekennzeichnet,**
**dass** eine Temperatursteuerungseinrichtung (89; 96) vorgesehen ist, die mit den Temperatursensoren (82", 83", 84"; 90', 90", 91', 91 ", 92', 92", 93', 93", 94', 94") über Signalleitungen verbunden ist und die über Steuerleitungen mit den individuell ansteuerbaren Wärmeleiteinrichtungen (82, 83, 84) und/oder Kühl- und/oder Heizeinrichtungen (90, 91, 92, 93, 94) verbunden ist.

15. Modularer Satellit nach Anspruch 14,
**dadurch gekennzeichnet,**
**dass** die Temperatursteuerungseinrichtung (89; 96) auf der Grundplatte (10; 11) oder in die Grundplatte (10; 11) integriert vorgesehen ist.
